# EUROPEAN PATENT APPLICATION

(11) **EP 0 969 058 A2**
(43) Date of publication of application: **05.01.2000**
(21) Application number: 99112719.2
(22) Date of filing: 01.07.1999
(51) Int. Cl.: C09J 4/00, C08F 290/06, C08F 299/02, H05K 3/38

(54) **Method of making encapsulated electronic component with reworkable package encapsulants**

(30) Priority: 02.07.1998 US 109189
(71) Applicant: National Starch and Chemical Investment Holding Corporation, Wilmington, Delaware 19803-7663 (US)
(72) Inventor: Ma, Bodan, Weehawken, New Jersey 07087 (US); Tong, Quinn K., Belle Mead, New Jersey 08502 (US); Xiao, Chaodong, East Hanover, New Jersey 07936 (US)
(74) Representative: Held, Stephan, Dr.rer.nat., Dipl.-Chem.

(57) **Abstract**

A method for preparing an encapsulated electronic component using a reworkable encapsulant composition comprising a major amount of mono-functional maleimide compounds, or mono-functional vinyl compounds other than maleimide compounds, or a combination of mono-functional maleimide and vinyl compounds, a curing initiator and optionally, one or more fillers or adhesion promoters comprising curing the composition in situ.

## Description

This invention relates to a method of making an encapsulated electronic component using reworkable package encapsulant compositions that protect the electronic component and its metallization from environmental corrosion and mechanical damage.

Microelectronic devices contain millions of electrical circuit components, mainly transistors assembled in integrated circuit (IC) chips, but also resistors, capacitors, and other components. These electronic components are interconnected to form the circuits, and eventually are connected to and supported on a carrier or substrate, such as a printed wire board.

The various materials used to manufacture the electronic components are susceptible to environmental, moisture, and mechanical damage. Protection is provided by encapsulation of the component within a polymeric material.

Encapsulation can be performed by a transfer molding process in which the electronic component is loaded into a mold cavity, constrained, and the polymeric encapsulant transferred from a reservoir into the cavity under pressure. Typically, the encapsulant is a thermosetting polymer, which then cross-links and cures to form the final assembly.

Encapsulation can also be performed by dispensing an aliquot of encapsulant composition onto the component, such as a chip or integrated circuit supported on a substrate, and subsequently curing the composition. For most commercial and industrial end uses, particularly those utilizing chip-on-board packages and multi-chip modules, the encapsulation is accomplished with polymeric thermosetting materials.

For single chip packaging involving high volume commodity products, a failed chip can be discarded without significant loss. However, it becomes expensive to discard multi-chip packages with only one failed chip, and the ability to rework the failed component would be a manufacturing advantage. Today, one of the primary thrusts within the semiconductor industry is to develop not only a package encapsulant that will meet all the requirements for protection of the component, but also a package encapsulant that will be reworkable, allowing for the failed component to be removed without destroying the substrate.

In order to achieve the required mechanical performance and reworkability, relatively high molecular weight thermoplastics would be the preferred compositions for package materials. These materials, however, have high viscosity or even solid film form, which are drawbacks to the manufacturing process. Therefore, there is a need for new encapsulant compositions that are easily dispensable to conform with automated manufacturing processes, and that are reworkable.

This invention is a method for making an encapsulated electronic component using a reworkable encapsulant composition. The composition is designed to be reworkable by choosing a major amount of mono-functional compounds for the composition.

The ability to process these thermoplastic compositions for package encapsulants is achieved by using relatively low molecular weight reactive oligomers or pre-polymers and curing them *in situ* after application to the electronic assembly. The relatively low molecular weight translates to a lower viscosity and ease of application.

The electronic component is electrically and mechanically connected to a substrate and encapsulated in a polymeric material herein referred to as the encapsulant composition.

The composition comprises one or more compounds containing one or more maleimide functionality, or one or more compounds containing one or more vinyl functionality, or a combination of compounds containing maleimide or vinyl functionality, a free-radical initiator and/or a photoinitiator, and optionally one or more fillers.

A compound containing one maleimide functionality will be referred to hereinafter as a mono-functional maleimide compound. A compound containing more than one maleimide functionality will be referred to hereinafter as a poly-functional maleimide compound. A compound containing one vinyl functionality will be referred to hereinafter as a mono-functional vinyl compound. A compound containing more than one vinyl functionality will be referred to hereinafter as a poly-functional vinyl compound. The functionality is defined herein to be a carbon to carbon double bond.

The method comprises the steps:
(a) providing a curable encapsulant composition comprising
   (i) one or more mono-functional maleimide compounds, or one or more mono-functional vinyl compounds other than maleimide compounds, or a combination of maleimide and vinyl compounds, in a major amount effective to provide thermoplastic properties, and
   (ii) optionally, one or more poly-functional maleimide compounds, or one or more poly-functional vinyl compounds other than maleimide compounds, or a combination of poly-functional maleimide and vinyl compounds, in a minor amount ineffective to diminish the thermoplastic properties of the cured composition,
   (iii) a curing initiator selected from the group consisting of a free-radical initiator, a photoinitiator, and a combination of those;
   (iv) optionally, one or more fillers; and
   (v) optionally, one or more adhesion promoters;
(b) applying the curable composition to the electronic component to encapsulate the component; and
(c) curing the composition *in situ*.

The maleimide and vinyl compounds used in the package encapsulant compositions of this invention are curable compounds, meaning that they are capable of polymerization, with or without crosslinking. As used in this specification, to cure will mean to polymerize, with or without crosslinking. Cross-linking, as is understood in the art, is the attachment of two polymer chains by bridges of an element, a molecular group, or a compound, and in general will take place upon heating. As cross-linking density is increased, The properties of a material can be changed from thermoplastic to thermosetting.

It is possible to prepare polymers of a wide range of cross-link density by the judicious choice and amount of mono- or polyfunctional compounds. The greater proportion of polyfunctional compounds reacted, the greater the cross-link density. In order to provide thermoplastic properties, the package encapsulants of this invention will be prepared from mono-functional compounds to limit the cross-link density. However, a minor amount of poly-functional compounds can be added to provide some cross-linking and strength to the composition, provided the amount of poly-functional compounds is limited to an amount that does not diminish the desired thermoplastic properties. Within these parameters, the strength and elasticity of individual package encapsulants can be tailored to a particular end-use application. The cross-link density can also be controlled to give a wide range of glass transition temperatures in the cured encapsulant to withstand subsequent processing and operation temperatures.

In those cases where it is necessary to rework the assembly, the electronic component can be pried off the substrate, and any residue package encapsulant can be heated until it softens and is easily removed.

In the inventive package encapsulant compositions, the maleimide compounds and the vinyl compounds may be used independently, or in combination. The maleimide or vinyl compounds, or both, will be present in the curable package encapsulant compositions in an amount from 2 to 98 weight percent based on the organic components present (excluding any fillers).

The package encapsulant compositions will further comprise at least one free-radical initiator, which is defined to be a chemical species that decomposes to a molecular fragment having one or more unpaired electrons, highly reactive and usually short-lived, which is capable of initiating a chemical reaction by means of a chain mechanism. The free-radical initiator will be present in an amount of 0.1 to 10 percent, preferably 0.1 to 3.0 percent, by weight of the maleimide or vinyl compound, or a combination of both maleimide and vinyl compounds (excluding any filler). The free radical curing mechanism gives a fast cure and provides the composition with a long shelf life before cure. Preferred free-radical initiators include peroxides, such as butyl peroctoates and dicumyl peroxide, and azo compounds, such as 2,2'-azobis(2-methyl-propanenitrile) and 2,2'-azobis(2-methyl-butanenitrile).

Alternatively, the encapsulant compositions may contain a photoinitiator, such as is sold by Ciba Specialty Chemicals under the trademark Irgacure, in lieu of the free-radical initiator, and the curing process may then be initiated by UV radiation. The photoinitiator will be present in an amount of 0.1 to 10 percent, preferably 0.1 to 3.0 percent, by weight of the maleimide or vinyl compound, or a combination of both maleimide and vinyl compounds (excluding any filler). In some cases, both photoinitiation and free-radical initiation may be desirable. For example, the curing process can be started by UV irradiation, and in a later processing step, curing can be completed by the application of heat to accomplish a free-radical cure.

In general, these compositions will cure within a temperature range of 80° to 180°C, and curing will be effected within a length of time of 5 minutes to 4 hours. As will be understood, the time and temperature curing profile for each encapsulant composition will vary, and different compositions can be designed to provide the curing profile that will be suited to the particular industrial manufacturing process.

For some package operations, inert inorganic fillers are used to adjust the coefficient of thermal expansion to more closely mirror that of the substrate. Examples of suitable thermally conductive fillers include silica, graphite, aluminum nitride, silicon carbide, boron nitride, diamond dust, and clays. The fillers will be present typically in an amount of 20-80 percent by weight of the total package encapsulant composition.

As used throughout this specification: the notation C(O) refers to a carbonyl group.

### Maleimide Compounds

The maleimide compounds suitable for use in the package encapsulant compositions of this invention have a structure represented by the formula:
[M-X ₘ]ₙ - Q , or by the formula: [M-Z ₘ]ₙ - K. For these specific formulae, when lower case "n" is the integer 1, the compound will be a mono-functional compound; and when lower case "n" is an integer 2 to 6, the compound will be a poly-functional compound.

Formula [M-X ₘ]ₙ - Q represents those compounds in which:
M is a maleimide moiety having the structure 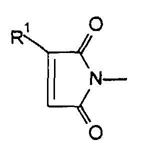 in which R¹ is H or C₁ to C₅ alkyl;
each X independently is an aromatic group selected from the aromatic groups having the structures (I) through (V): 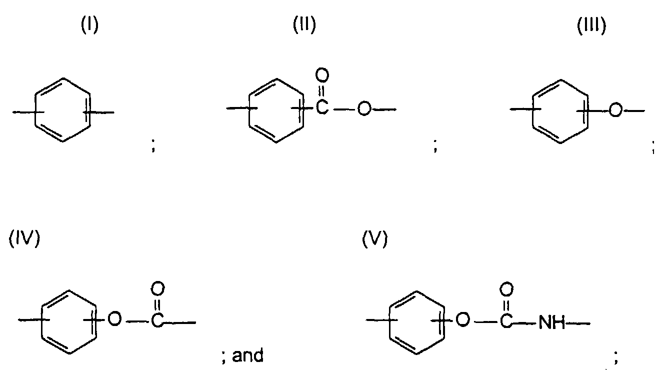
and Q is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the backbone in the chain, and in which any heteroatom present may or may not be directly attached to X;
or Q is a urethane having the structure: 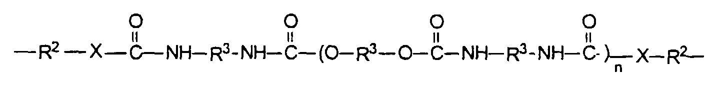 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50;
or Q is an ester having the structure: 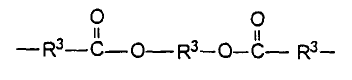 in which R³ is an alkyl or alkyloxy chain having up to 100 atoms in the chain, which chain may contain aryl substituents;
or Q is a siloxane having the structure: ―(CR¹₂)ₑ-[SiR⁴-O]_{f}-SiR⁴₂-(CR¹₂)_{g}- in which the R¹ substituent independently for each position is H or an alkyl group having 1 to 5 carbon atoms and the R⁴ substituent independently for each position is an alkyl group having 1 to 5 carbon atoms or an aryl group, and e and g are independently 1 to 10 and f is 1 to 50; and
m is 0 or 1, and n is 1 to 6.

Preferably, X is structure (II), (III), (IV) or (V), and more preferably is structure (II).

Preferably, Q is a linear or branched chain alkyl, alkyloxy, alkylene, or alkyleneoxy species having up to about 100 atoms in the chain, as described with pendant saturated or unsaturated cyclic or heterocyclic substituents, or a siloxane as described, and more preferably is a linear or branched chain alkyl species or siloxane, as described.

Formula [M-Z ₘ]ₙ - K represents those compounds in which
M is a maleimide moiety having the structure 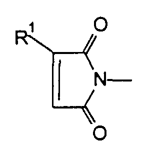 in which R¹ is H or C₁ to C₅ alkyl;
Z is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the backbone in the chain, and in which any heteroatom present may or may not be directly attached to K;
or Z is a urethane having the structure: 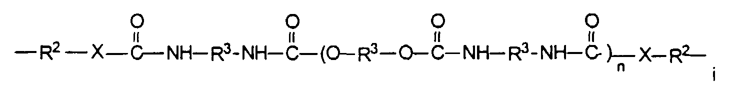 n which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50;
or Z is an ester having the structure: 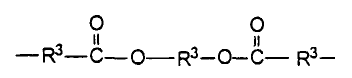 in which R³ is an alkyl or alkyloxy chain having up to 100 atoms in the chain, which chain may contain aryl substituents;
or Z is a siloxane having the structure:
   ―(CR¹₂)e-[SiR⁴₂-O]_{f}-SiR⁴₂-(CR¹₂)g― in which the R¹ substituent independently for each position is H or an alkyl group having 1 to 5 carbon atoms and the R⁴ substituent independently for each position is an alkyl group having 1 to 5 carbon atoms or an aryl group, and e and g are independently 1 to 10 and f is 1 to 50; and
K is an aromatic group selected from the aromatic groups having the structures (VI) through (XIII) (although only one bond may be shown to represent connection to the aromatic group K, this will be deemed to represent any number of additional bonds as described and defined by n): 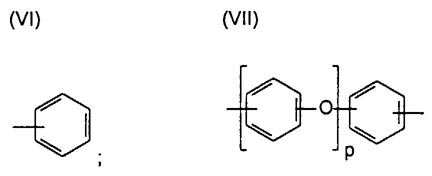 in which p is 1 to 100; 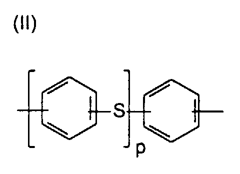 in which p is 1 to 100; 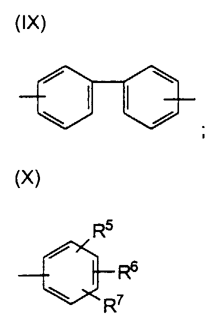 in which R⁵, R⁶, and R⁷ are a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the backbone in the chain, and in which any heteroatom present may or may not be directly attached to the aromatic ring; or R⁵, R⁶, and R⁷ are a siloxane having the structure ―(CR¹₂)ₑ-[SiR⁴₂-O]_{f}-SiR⁴₂-(CH₃)_{g}- in which the R¹ substituent is H or an alkyl group having 1 to 5 carbon atoms and the R⁴ substituent independently for each position is an alkyl group having 1 to 5 carbon atoms or an aryl group, and e is 1 to 10 and f is 0 to 50; 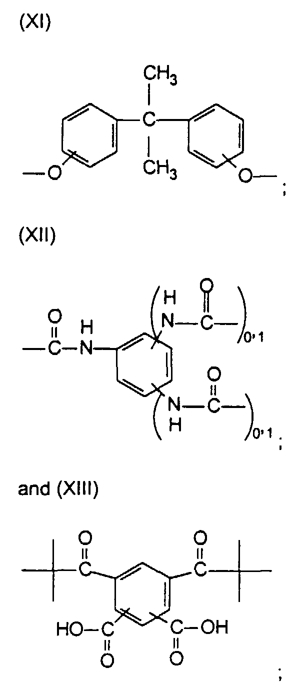 and m is 0 or 1, and n is 1 to 6.

Preferably, Z is a linear or branched chain alkyl, alkyloxy, alkylene, or alkyleneoxy species having up to about 100 atoms in the chain, as described with pendant saturated or unsaturated cyclic or heterocyclic substituents, or a siloxane as described, and more preferably is a linear or branched chain alkyl species or siloxane, as described.

Preferably, K is structure (VIII), (X) or (XI), more preferably is structure (X) or (XI), and most preferably is structure (X).

The preferred maleimide compounds are N-butylphenyl maleimide, and N-ethylphenyl maleimide.

### Vinyl Compounds

The vinyl compounds (other than the maleimides herein) suitable for use in the package encapsulant compositions of the invention will have the structure:

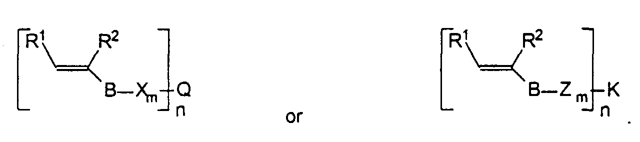

For these specific structures, when lower case "n" is the integer 1, the compound will be a mono-functional compound; and when lower case "n" is an integer 2 to 6, the compound will be a poly-functional compound.

In these structures, R¹ and R² are H or an alkyl having 1 to 5 carbon atoms, or together form a 5 to 9 membered ring with the carbons forming the vinyl group; B is C, S, N, O, C(O), O-C(O), C(O)-O, C(O)NH or C(O)N(R⁸), in which R⁸ is C₁ to C₅ alkyl; m is 0 or 1; n is 1-6; and X, Q, Z, and K are as described above.

Preferably, B is O, C(O), O-C(O), C(O)-O, C(O)NH or C(O)N(R⁸); more preferably, B is O, C(O), O-C(O), C(O)-O, or C(O)N(R⁸).

### Other Composition Components

Depending on the nature of the substrate to which the package encapsulant is to be bonded, the encapsulant may also contain a coupling agent. A coupling agent as used herein is a chemical species containing a polymerizable functional group for reaction with the maleimide and other vinyl compound, and a functional group capable of condensing with metal hydroxides present on the surface of the substrate. Such coupling agents and the preferred amounts for use in compositions for particular substrates are known in the art. Suitable coupling agents are silanes, silicate esters, metal acrylates or methacrylates, titanates, and compounds containing a chelating ligand, such as phosphine, mercaptan, and acetoacetate. When present, coupling agents typically will be in amounts up to 10 percent by weight, and preferably in amounts of 0.1 to 3.0 percent by weight, of the maleimide and other monofunctional vinyl compound.

In addition, the encapsulant compositions may contain compounds that lend additional flexibility and toughness to the resultant cured encapsulant. Such compounds may be any thermoset or thermoplastic material having a Tg of 50°C or less, and typically will be a polymeric material characterized by free rotation about the chemical bonds, such as can be obtained by the presence of carbon-carbon double bonds adjacent to carbon-carbon single bonds, the presence of ester and ether groups, and the absence of ring structures. Suitable such modifiers include polyacrylates, poly(butadiene), polyTHF (polymerized tetrahydrofuran), CTBN (carboxy-terminated butyronitrile) rubber, and polypropylene glycol. When present, toughening compounds may be in an amount up to about 15 percent by weight of the maleimide and other monofunctional vinyl compound.

If siloxane moieties are not part of the maleimide or vinyl compound structure, siloxanes can be added to the package formulations to impart elastomeric properties. Suitable siloxanes are the methacryloxypropyl-terminated polydimethyl siloxanes, and the aminopropyl-terminated polydimethylsiloxanes, available from United Chemical Technologies.

Other additives known and used in the art may also be used for specific purposes, such as, adhesion promoters. The selection of the types and amounts suitable is within the expertise of one skilled in the art.

### EXAMPLES

Various maleimide and vinyl compounds were prepared and formulated into package encapsulant compositions. The compositions were investigated for viscosity and thixotropic index for the uncured composition, and for curing profile, glass transition temperature, coefficient of thermal expansion, thermal mechanical analysis, and reworkability for the cured composition.

### EXAMPLE 1.

### Preparation of Benzamido-endcapped Dimer Diamine Bismaleimide

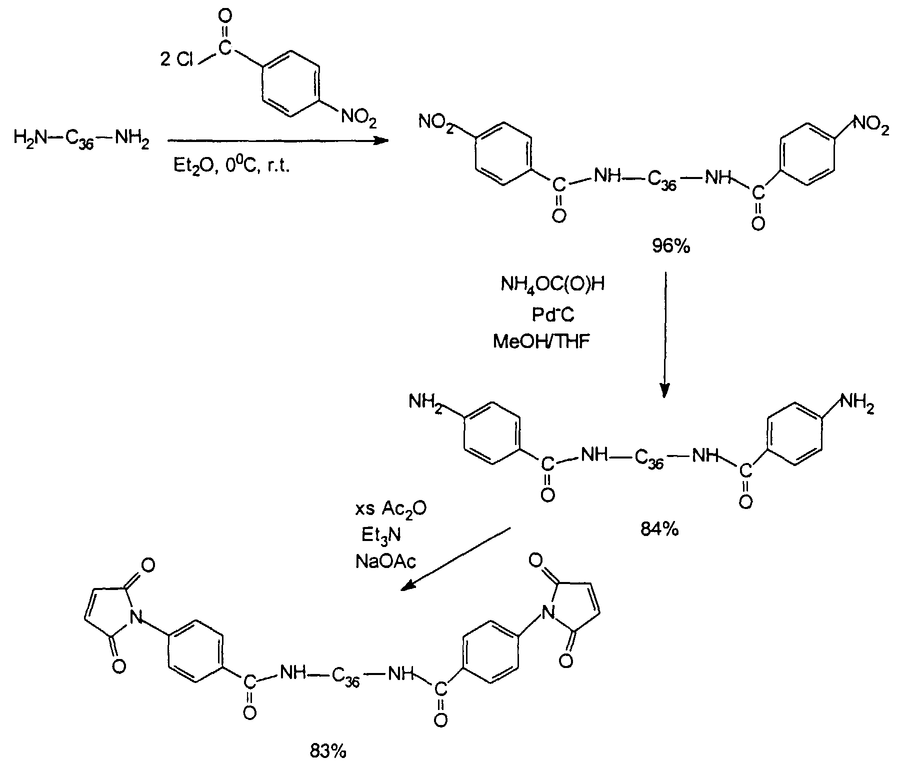

Dimer diamine (sold as Versamine 552 by Henkel, 20.0 g, 37 mmol) was solvated in diethyl ether (Et₂O) (200 mL) in a 500 mL three-necked flask equipped with an addition funnel, magnetic stirring, internal temperature probe and nitrogen inlet/outlet. NaOH_{aq} (11. 7 mL of 6.25 M solution diluted with 100 mL H₂O, 73 mmol) was added with vigorous stirring. This solution was placed under a steady flow of nitrogen and cooled to 3°C on an ice bath with stirring. The addition funnel was charged with *p*-nitrobenzoyl chloride (13.6 g, 73 mmol) in Et₂O (50 mL), and this solution was added to the reaction vessel over the course of 60 minutes, maintaining an internal T<10°C. The reaction was stirred at ∼3°C for an additional 60 minutes after this addition was complete, then allowed to warm to room temperature and stirred for another 4 hours. The solution was transferred to a separatory funnel and the isolated organic layer washed with distilled H₂O (300 mL), 5% HCl_{aq} (300 mL), NaCl_{aq} (250 mL) and distilled H₂O (2x250 mL). The organics were isolated, dried over MgSO₄ anhyd., filtered and the solvent removed *in vacuo* to yield the dinitro compound as a viscous yellow oil which exhibited acceptable ¹H NMR and IR spectra (30.0 g, 96 %).

The dinitro compound described above (5.0 g, 5.9 mmol) was dissolved in methanol (MeOH) (25 mL) and tetrahydrofuran (THF) (5 mL) in a 250 mL three-necked flask equipped with magnetic stirring, reflux condenser and nitrogen inlet/outlet. The solution was placed under nitrogen, and 5% Pd-C (0.96 g) were added with stirring. Ammonium formate (3.4 g, 55 mmol) was added and the reaction stirred at room temperature for 2 hours. Carbon dioxide evolution was immediately observed. The reaction solution was filtered, and bulk filtrate solvent was removed via rotary evaporator. The resulting viscous oil was dissolved in (Et₂O) (150 mL), washed with distilled H₂O (150 mL), isolated and dried over MgSO₄ anhyd. Solvent was removed *in vacuo* to yield the diamine as a sticky tan oil, which exhibited acceptable ¹H NMR and IR spectra (3.9 g, 84%).

Maleic anhydride (0.5 g, 5.1 mmol) was dissolved in acetone (10 mL) in a 250 mL three-necked flask equipped with magnetic stirring, addition funnel and nitrogen inlet/outlet. The solution was cooled on an ice bath and placed under nitrogen. The addition funnel was charged with an acetone (10mL) solution of the diamine described above (2.0 g, 2.60 mmol), which was added dropwise over 30 minutes. The reaction was stirred for an additional 30 minutes on the ice bath, then allowed to warm to room temperature, and stirred for another 4 hours. To the resulting slurry was added acetic anhydride (Ac₂O) (1.54 mL, 160 mmol), triethyl amine (Et₃N) (0.23 mL, 1.63 mmol) and sodium acetate (NaOAc) (0.16 g, 1.9 mmol). The resulting slurry was heated to mild reflux for 5 hours. The reaction was allowed to cool to room temperature, and solvent removed *via* rotary evaporator to yield a brown oil. This material was dissolved in CH₂Cl₂ (250 mL) and washed with distilled H₂O (200mL), satd. NaHCO₃ (200 mL) and distilled H₂O (200 mL). Emulsions were broken by adding NaCl when necessary. The organic layer was isolated, dried over MgSO₄ anhyd. and solvent removed *in vacuo* to yield the bismaleimide, a brown solid (2.0 g, 83%). The resin exhibited satisfactory ¹H NMR, ¹³C NMR and IR spectra, which indicated slight contamination with acetic acid.

### EXAMPLE 2

### Preparation of 20-Bismaleimido-10,11-dioctyl-eicosame (and isomers)

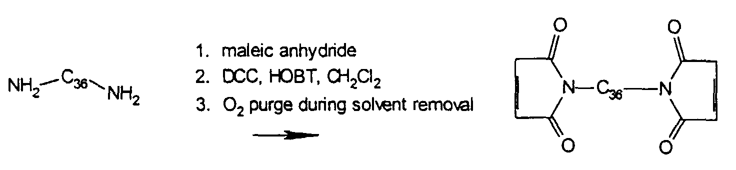

In a 5 L multi-neck flask equipped with a drying tube, thermometer, slow addition funnel , mechanical stirrer and nitrogen purge maleic anhydride (98.06 g, 1.02 equivalents on -NH₂) was dissolved in 500 ml tetrahydrofuran (THF). Stirring was begun and the solution was chilled with a dry ice/water bath. Slow addition of dimer diamine (Versamine 552, Henkel, 245.03 g, 0.4477 mol) in 250 ml THF was begun. Addition was carried out over 1 hour. After addition was complete the ice bath was removed and 375 ml of THF was rinsed through the slow addition funnel to incorporate solidified diamine. After one hour the ice bath was replaced around the flask. 1-Hydroxybenzotriazole (96.79 g, 0.80 equivalents on -NH₂) was added rinsing into the flask with 50ml THF. When the temperature had reached 5°C slow addition of dicyclohexylcarbodilmide (DCC) (188.43 g, 1.02 equivalents on -NH₂) in 200ml THF was begun. The temperature during addition was kept below ten degrees. After DCC addition was complete the slow addition funnel was rinsed with 80 ml of THF. The ice bath was removed. The reaction was monitored by IR. When it appeared that the isoimide has been converted to maleimide (approximately 4 hours after the completion of DCC addition) the mixture was filtered, rinsing the solids with THF. The orange solution was placed in the freezer overnight.

The solution was removed from the freezer and allowed to warm to room temperature. Hydroquinone (0.0513 g) was added to the solution. A partial strip of the THF was carried out on a rotary evaporator with the temperature maintained below 28°C. The solution was concentrated to approximately 800 ml. Much particulate matter was visible. The solution was placed in freezer overnight.

The mixture was removed from the freezer and allowed to warm. The solids were filtered, rinsing with THF. The filtrate was transferred to a 2 L multi-neck flask equipped with a mechanical stirrer, vacuum line connected to a trap, and a glass tube attached by tubing to a drying tube. The remaining THF was stripped at room temperature by pulling a vacuum and bubbling air through the material while stirring. The resultant thick, creamy-tan colored semi-solid was placed in the freezer overnight.

The semi-solid was removed from the freezer and allowed to warm. The semi-solid was dissolved in 450 ml each of methanol and hexane, and washed with 50% methanol/water (4 x 250 ml) to remove 1-hydroxybenzotriazole (HOBT). It was attempted to extract the product with hexane. After addition of 300 ml of hexane separation was not observed. The mixture was washed with additional water (3 x 250 ml). The organic phase was placed in the freezer overnight.

The material was removed from the freezer. Two layers were apparent. The upper layer was clear and yellow in color. The bottom layer was a orange and cloudy. The material was poured cold into a separatory funnel. The top layer was hexane and the desired product. The bottom layer was extracted with hexane (6 x 200 ml), separation occurred easily. The combined extracts were dried over anhydrous magnesium sulfate and filtered, rinsing the solids with hexane. The solvent was stripped to an approximate volume of 750 ml on a rotary evaporator with the temperature not exceeding 24°C. The remaining solvent was stripped off using a vacuum/air bubbling set-up at room temperature to give the desired product in 67% yield.

### EXAMPLE 3

### Preparation of Butadiene-Acrylonitrile Bismaleimide

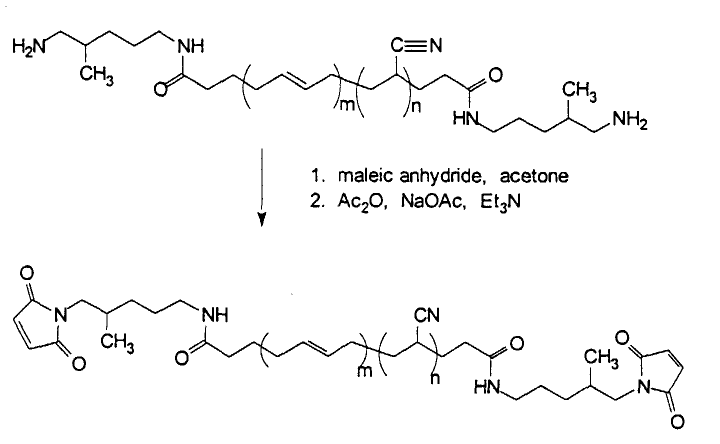

Amino-terminated butadiene-acrylonitrile (sold as Hycar resin 1300 X42 ATBN by BF Goodrich, in which the m and n depicted in the structure are integers to provide a number average molecular weight of 3600) (450 g, 500 mmol based on amine equivalent weight AEW = 450g) was dissolved in CHCl₃ (1000 mL) in a 3 L four-necked flask equipped with addition funnel, mechanical stirrer, internal temperature probe and nitrogen inlet/outlet. The stirred solution was placed under nitrogen and cooled on an ice bath. The addition funnel was charged with maleic anhydride (98.1 g, 1 mol) in CHCl₃ (50 mL) and this solution was added to the reaction over 30 minutes, maintaining the internal reaction temperature below 10°C. The resulting slurry was stirred for 30 minutes on ice, then allowed to warm to room temperature and stirred for an additional 4hours. To the resulting slurry was added acetic anhydride (Ac₂O) (653.4 g, 6 mol), triethyl amine (Et₃N) (64.8 g, 0.64 mol) and sodium acetate (NaOAc) (62.3 g, 0.76 mol). The reaction was heated to mild reflux for 5 hours, allowed to cool to room temperature, and subsequently extracted with H₂O (1 L), satd. NaHCO₃ (1 L) and H₂O (2x1 L). Solvent was removed *in vacuo* to yield the maleimide terminated butadiene acrylonitrile.

### EXAMPLE 4

### Preparation of Tris(maleimide) Derived From Tris(epoxypropyl)isocyanurate

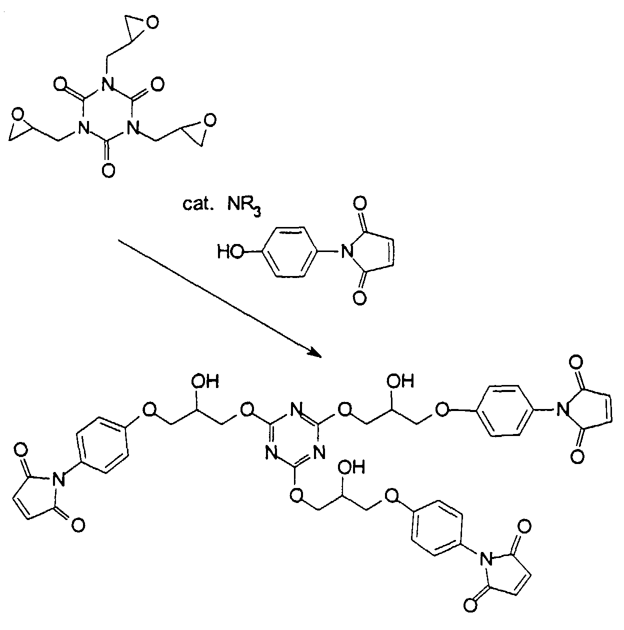

Tris(epoxypropyl)isocyanurate (99.0 g, 0.33 mol) is dissolved in THF (500mL) in a 2 L three-necked flask equipped with mechanical stirrer, internal temperature probe and nitrogen inlet/outlet. To this solution is added hyroxyphenylmaleimide (189.2 g, 1 mol) and benzyldimethylamine (1.4g. 0.05 wt. %). The solution is heated to 80°C for 7 hours. The reaction is allowed to cool to room temperature, is filtered, and the filtrant washed with 5 % HCl_{aq} (500mL) and distilled H₂O (1 L). The resulting solid, triazinetris(maleimide), is vacuum dried at room temperature.

### EXAMPLE 5

### Preparation of Maleimidoethylpalmitate

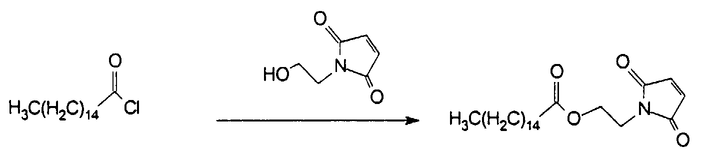

Palmitoyl chloride (274.9 g, 1 mol) is dissolved in Et₂O (500 mL) in a 2 L three-necked flask equipped with mechanical stirrer, internal temperature probe, addition funnel and nitrogen inlet/outlet. NaHCO₃ (84.0 g, 1 mol) in distilled H₂O (500 mL) is added with vigorous stirring and the solution cooled on an ice bath under nitrogen. The addition funnel is charged with hydroxyethylmaleimide (141 g, 1 mol) in Et₂O (100 mL) and this solution added to the reaction over a period of 30 minutes, maintaining an internal T<10°C during the addition. The reaction is stirred for another 30 minutes on ice, then allowed to warm to room temperature and stirred for 4 hours. The reaction is transferred to a separatory funnel and the isolated organic layer washed with distilled H₂O (500 mL), 5% HCl_{aq} (500 mL) and distilled H₂O (2x500 mL). The organics are isolated, dried over MgSO₄ anhyd., filtered and solvent removed *in vacuo* to yield the aliphatic maleimide.

### EXAMPLE 6

### Preparation of Bismaleimide Derived from 5-Isocyanato-1-(isocyanatomethyl)-1, 3, 3-trimethylcyclohexane

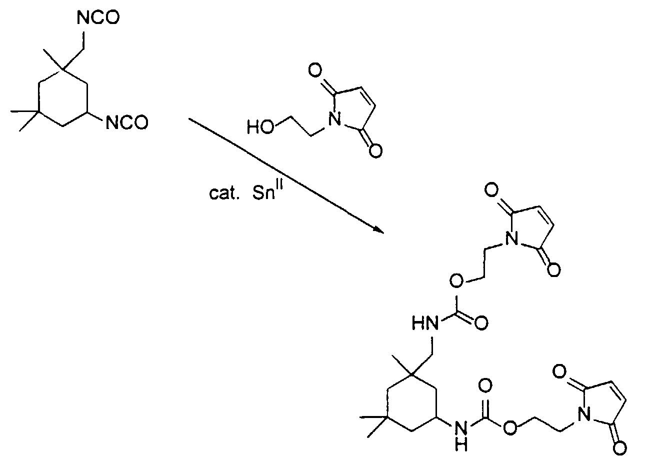

5-Isocyanato-1-(isocyanatomethyl)-1, 3, 3-trimethylcyclohexane (111.15 g, 0.5 mol) is solvated in THF (500 mL) in a 1 L three-necked flask equipped with mechanical stirrer, addition funnel and nitrogen inlet/outlet. The reaction is placed under nitrogen, and dibutyltin dilaurate (cat. Sn^{II}) (6.31 g, 10 mmol) added with stirring as the solution is heated to 70°C. The addition funnel is charged with hydroxyethylmaleimide (141 g, 1 mol) dissolved in THF (100 mL). This solution is added to the isocyanate solution over 30 minutes, and the resulting mixture heated for an additional 4 hours at 70°C. The reaction is allowed to cool to room temperature and solvent removed *in vacuo*. The remaining oil is dissolved in CH₂Cl₂ (1 L) and washed with 10% HCl_{aq} (1 L) and distilled H₂O (2x1 L). The isolated organics are dried over MgSO₄, filtered and the solvent removed *in vacuo* to yield the maleimide.

### EXAMPLE 7

### Preparation of Dimer Divinyl Ether Derived from Dimerized Oleic Acid Diol

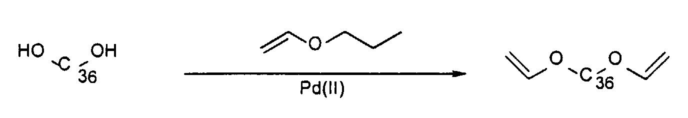

Bis(benzonitrile)palladium chloride (1.15 g, 5 mmol) is dissolved in a mixture of propyl vinyl ether (24.4 g, 3 mol) and oleic acid dimer diol (sold as Pripol 2033 by Unichema, 284.4 g, 500 mmol) in 2 L three-necked flask equipped with a mechanical stirrer under nitrogen. The solution is stirred for three days at room temperature, and then poured onto activated carbon (20 g) and stirred for 1 hour. The resulting slurry is filtered, and excess propyl vinyl ether removed *in vacuo* to yield the divinyl ether as a yellow oil.

### EXAMPLE 8

### Preparation of Dimer Diacrylate Derived From Dimerized Oleic Acid Diol

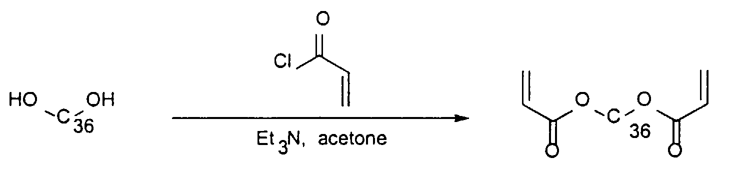

Oleic acid dimer diol (sold as Pripol 2033 by Unichema, 284.4 g, 500 mmol) is dissolved in dry acetone (500 mL) in a 1 L three-necked flask equipped with mechanical stirrer, addition funnel and internal temperature probe under nitrogen. Triethylamine (101.2 g, 1 mol) is added to this solution and the solution cooled to 4°C on an ice bath. Acryloyl chloride (90.5 g, 1 mol) solvated in dry acetone (100 mL) is charged into the addition funnel and added to the stirred reaction solution over the course of 60 minutes, maintaining an internal temperature <10°C. This solution is stirred on ice for an additional 2 hours, then allowed to warm to room temperature and stirred for 4 hours. Bulk solvent is removed via a rotary evaporator, and the remaining residue solvated in CH₂Cl₂ (1 L). This solution is washed with 5% HCl_{aq} (800 mL), and H₂O (2x800mL). The isolated organics are dried over MgSO₄ anhyd. and filtered, and the solvent removed i*n vacuo* to yield the diacrylate as an oil.

### EXAMPLE 9

### Preparation of N-ethylphenyl Maleimide

4-Ethyl aniline (12.12g) was dissolved in 50 ml of anhydrous ethyl ether and slowly added to a stirred solution of 9.81 g of maleic anhydride in 100 ml of anhydrous ethyl ether chilled in an ice bath. After completion of the addition, the reaction mixture was stirred for 30 minutes. The light yellow crystal was filtered and dried. Acetic anhydride (200 ml) was used to dissolve the maleamic acid and 20 g of sodium acetate. The reaction mixture was heated in an oil bath at 160°C. After 3 hours of reflux, the solution was cooled to room temperature, placed in a 1 L beaker in ice water and stirred vigorously for 1 hour. The product was suction-filtered and recrystallized in hexane. The collected crystalline material was dried at 50°C in a vacuum oven overnight. FTIR and NMR analysis showed the characteristics of ethyl maleimide.

### EXAMPLE 10

### Preparation of Bis(alkenylsulfide)

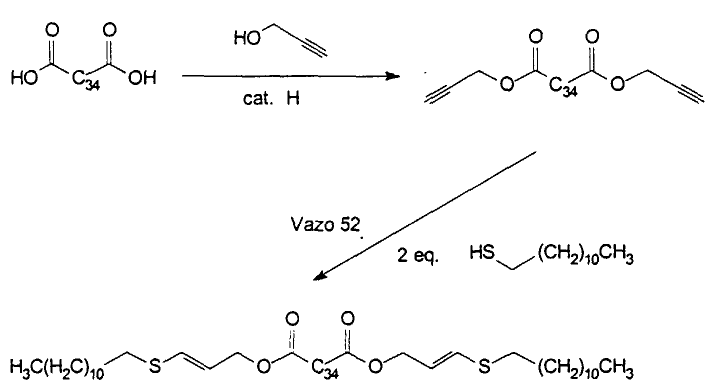

Dimer acid (sold under the trademark Empol 1024 by Unichema) (574.6 g, 1 mol) and propargyl alcohol (112.1 g, 2 mol) were solvated in toluene (1 L) in a 3 L three-necked flask equipped with mechanical stirring and a Dean-Stark distillation apparatus. Concentrated H₂SO₄ (6 mL) was added and the solution refluxed for 6 hours until 36 mL of H₂O was azeotropically distilled. The solution was allowed to cool to room temperature, washed with H₂O (2X1L), dried over MgSO₄ anhyd. and solvent removed *in vacuo* to yield the propargyl ester intermediate as an oil.

This ester intermediate (650.7 g, 1 mol) was solvated in THF (200 mL) in a 1L three-necked flask equipped with reflux condensor, mechanical stirrer and internal temperature probe under nitrogen. Lauryl mercaptan (404.8 g, 2 mol) and 2,2'-azobis(2,4-dimethylpentanenitrile) (sold under the trademark Vazo 52 by DuPont) (11 g) were added and the resulting mixture heated to 70°C on an oil bath with stirring for 7 hours. The reaction was allowed to cool to room temperature and solvent removed *in vacuo* to yield the mercaptan as an oil.

### EXAMPLE 11

### Package Encapsulant Compositions

Package encapsulant compositions were prepared by mixing together the organic components and then by blending the components with a silica filler in a weight percent ratio of 17% organic to 83% silica under high shear until homogeneous. The silica was FB-6S silica from Denka. The resulting compositions were light yellow slurries. The organic components, silica ratio by weight, glass transition temperature (Tg), and coefficient of thermal expansion (CTE) are reported here:

| Composition | Sample 11-A | Sample 11-B | Sample 11-C | Sample 11-D |
|---|---|---|---|---|
| Maleimide | N-4-butylphenyl maleimide | N-4-ethylphenyl maleimide | Dimer diamine bismaleimide | Bismaleimide * |
| | 22.9 g | 20.1 g | 1.0 g | 1.0 g |
| | 51.9 wt% | 48.7wt% | 82.0 wt% | 82.0 wt% |
| Vinyl-t-butylbenzoate | 20.4 g | 20.4 g | 0.2 g | 0.2 g |
| | 46.2 wt% | 49.4 wt% | 16.4 wt% | 16.4 wt% |
| Dicumyl peroxide | 0.45 g | 0.40 g | 0.01 g | 0.01g |
| | 1.0 wt% | 1.0 wt% | 0.8 wt% | 0.8 wt% |
| thacyloxytrimethoxysilane | 0.40 g | 0.40 g | 0.01 g | 0.01 g |
| | 0.9 wt % | 1.0 wt% | 0.8 wt% | 0.8 wt% |
| Tg | 140°C | 145°C | 42°C | 37°C |
| CTE | 16 ppm/°C | 15 ppm/°C | 16 ppm/°C | 15 ppm/°C |

| | | | | |
|---|---|---|---|---|
| *(prepared from polytetramethylene oxide-di-*p*-aminobenzoate, sold as Versalink P-650 by Henkel) | | | | |

### EXAMPLE 12

### Reworkability

Each composition 11-A to 11-D was tested for reworkability using as a test vehicle a 250X250 mil² silicon die bonded with the composition to a FR-4 circuit board substrate. The encapsulant composition was dispensed onto the chip adhered to the substrate and the assembly cured at 160°C for 30 minutes. After the assembly again reached room temperature, a sponge was saturated with methyl isobutyl ketone and used to wipe the encapsulant in a continuous, circular motion. The encapsulant was gradually softened, and it dissolved within 10 minutes sufficiently to leave no residue on the substrate.

This Example demonstrates that these compositions can be made to be reworkable.

### EXAMPLE 13

### UV and Thermally Curable Compositions

### Composition 13-A

A package encapsulant composition was prepared by combining the following ingredients with vigorous manual mixing until a homogenous paste was obtained:

| | |
|---|---|
| Bismaleimide (prepared from polytetramethylene oxide-di-*p*-aminobenzoate, sold as Versalink P-650 by Henkel) | 1.01 g |
| Cyclohexanedimethanol divinylether (International Specialty Products) | 0.19 g |
| α,α-Dimethoxy-α-phenylacetophenone (sold as Irgacure 651 by Ciba Specialty Chemicals) | 0.06 g |
| Hydrophilic Fused Silica (sold by Denka, ∼5 micron) | 3.78 g |

A 250 mil x 250 mil silicon die placed on FR-4 laminate was encapsulated with the above paste and irradiated for 30 seconds using a pulsed xenon UV source (RC-500B Pulsed UV Curing System, Xenon Corporation). The encapsulant exhibited a hard, fully cured surface and held the die firmly to the laminate material when force was applied. The sample assembly was subsequently placed in a 175°C oven for 20 minutes. The encapsulated die was allowed to cool to room temperature and then forcibly removed from the laminate. No regions of uncured encapsulant were detected around the die edge, the laminate/adhesive interface or the adhesive/air surface interface.

### Composition 13-B

A package encapsulant composition was prepared by combining the following ingredients with vigorous manual mixing until a homogenous paste was obtained:

| | |
|---|---|
| Bismaleimide (prepared from polytetramethylene oxide-di-*p*-aminobenzoate, sold as Versalink P-650 by Henkel) | 1.01 g |
| Cyclohexanedimethanol divinylether (International Specialty Products): | 0.19 g |
| *t*-Butyl-2-ethylhexanoate | 0.03 g |
| Hydrophilic Fused Silica (sold by Denka, ∼5 micron) | 3.78 g |

A 250 mil x 250 mil silicon die placed on FR-4 laminate was encapsulated with the above paste and placed in a 150°C oven for 30 min. The test assembly was allowed to cool to room temperature and the die was forcibly removed from the laminate. No regions of uncured encapsulant were detected around the die edge, the laminate/adhesive interface or the adhesive/air surface interface.

In accordance with this specification, various embodiments of the inventive method include, but are not limited to, those designated in the following numbered paragraphs:
1. The method for preparing an electronic component encapsulated in a cured reworkable encapsulant composition, in which the encapsulant composition comprises a mono-functional maleimide compound having the formula [M-X ₘ]ₙ - Q as described herein in which X is selected from the group of aromatic groups having the structures 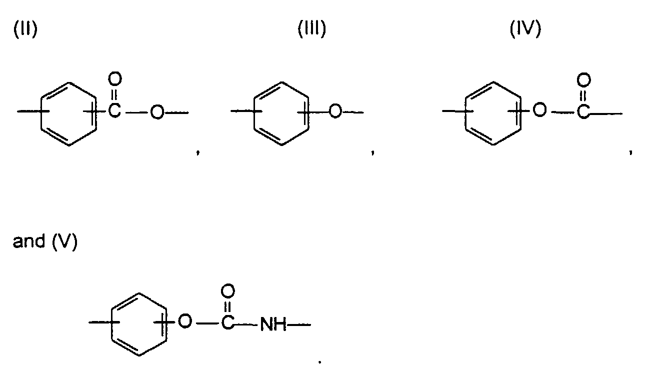
2. The method for preparing an encapsulated electronic component according to paragraph 1 in which Q is a linear or branched chain alkyl, alkyloxy, alkylene, or alkyleneoxy species having up to about 100 atoms in the chain, which may contain saturated or unsaturated cyclic or heterocyclic substituents pendant from the chain or as part of the chain.
3. The method for preparing an encapsulated electronic component according to paragraph 1 in which Q is a linear or branched chain alkyl species having up to about 100 atoms in the chain, which may contain saturated or unsaturated cyclic or heterocyclic substituents pendant from the chain or as part of the chain.
4. The method for preparing an encapsulated electronic component according to paragraph 1 in which Q is a urethane having the 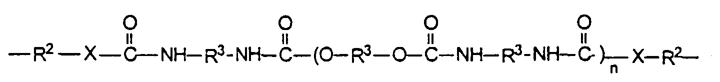 structure: in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50.
5. The method for preparing an encapsulated electronic component according to paragraph 1 in which Q is an ester having the structure: 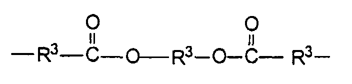 in which R³ is an alkyl or alkyloxy chain having up to 100 atoms in the chain, which chain may contain aryl substituents.
6. The method for preparing an encapsulated electronic component according to paragraph 1 in which Q is a siloxane having the structure:

   ―(CR¹₂)ₑ-[SiR⁴₂-O]_{f}-SiR⁴₂-(CR¹₂)_{g}-

   in which the R' substituent independently for each position is H or an alkyl group having 1 to 5 carbon atoms, and the R⁴ substituent independently for each position is an alkyl group having 1 to 5 carbon atoms or an aryl group, and e and g are independently 1 to 10 and f is 1 to 50.
7. The method for preparing an electronic component encapsulated in a cured reworkable encapsulant composition, in which the encapsulant composition comprises a mono-functional maleimide compound having the formula [M-Z ₘ]ₙ - K as described herein, in which Z is a linear or branched chain alkyl, alkyloxy, alkylene, or alkyleneoxy species having up to about 100 atoms in the chain, which may contain saturated or unsaturated cyclic or heterocyclic substituents pendant from the chain or as part of the chain.
8. The method for preparing an encapsulated electronic component according to paragraph 7 in which Z is a linear or branched chain alkyl species having up to about 100 atoms in the chain, which may contain saturated or unsaturated cyclic or heterocyclic substituents pendant from the chain or as part of the chain.
9. The method for preparing an encapsulated electronic component according to paragraph 7 in which Z is a urethane having the structure: 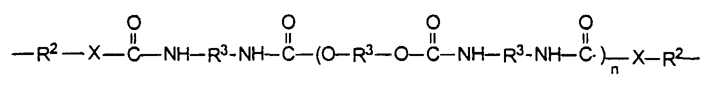 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50.
10. The method for preparing an encapsulated electronic component according to paragraph 7 in which Z is an ester having the structure: 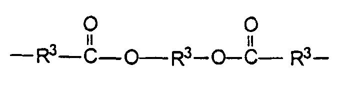 in which R³ is an alkyl or alkyloxy chain having up to 100 atoms in the chain, which chain may contain aryl substituents.
11. The method for preparing an encapsulated electronic component according to paragraph 7 in which Z is a siloxane having the structure:

   ―(CR¹₂)ₑ-[SiR⁴₂-O]_{f}-SiR⁴₂-(CR¹₂)_{g}―

   in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10, and f is 1 to 50.
12. The method for preparing an encapsulated electronic component according to paragraph 7 in which K is 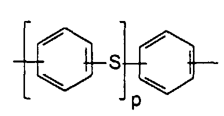 in which p is 1 to 100.
13. The method for preparing an encapsulated electronic component according to paragraph 7 in which K is 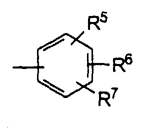 in which R⁵, R⁶, and R⁷ are a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain, and in which any heteroatom present may or may not be directly attached to the aromatic ring.
14. The method for preparing an encapsulated electronic component according to paragraph 7 in which K is 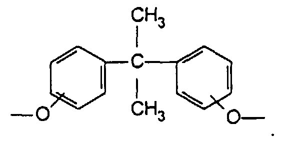
15. The method for preparing an encapsulated electronic component encapsulated in a cured reworkable encapsulant composition, in which the encapsulant composition comprises a mono-functional vinyl compound having the formula 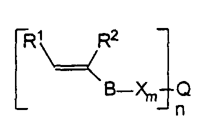 as described herein in which B is selected from the group consisting of O, C(O), O-C(O), C(O)-O, C(O)NH and C(O)N(R⁸).
16. The method for preparing an encapsulated electronic component according to paragraph 15 in which X is selected from the group of aromatic groups having the structures 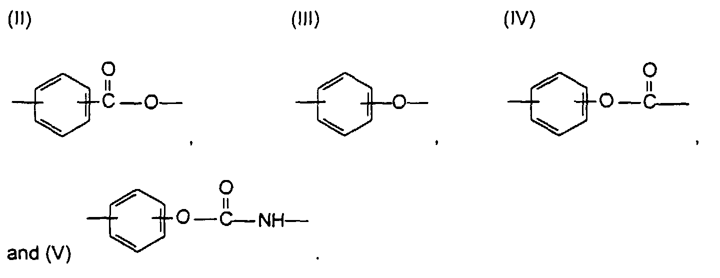
17. The method for preparing an encapsulated electronic component according to paragraph 15 in which X is 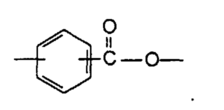
18. The method for preparing an encapsulated electronic component according to paragraph 15 in which Q is a linear or branched chain alkyl, alkyloxy, alkylene, or alkyleneoxy species having up to about 100 atoms in the chain, which may contain saturated or unsaturated cyclic or heterocyclic substituents pendant from the chain or as part of the chain.
19. The method for preparing an encapsulated electronic component according to paragraph 15 in which Q is a linear or branched chain alkyl species having up to about 100 atoms in the chain, which may contain saturated or unsaturated cyclic or heterocyclic substituents pendant from the chain or as part of the chain.
20. The method for preparing an encapsulated electronic component according to paragraph 15 in which Q is a urethane having the structure: 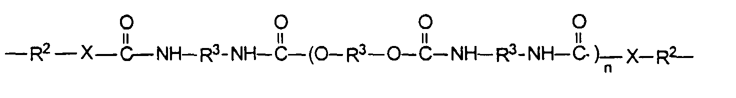 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50.
21. The method for preparing an encapsulated electronic component according to paragraph 15 in which Q is an ester having the structure: 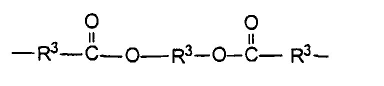 in which R³ is an alkyl or alkyloxy chain having up to 100 atoms in the chain, which chain may contain aryl substituents.
22. The method for preparing an encapsulated electronic component according to paragraph 15 in which Q is a siloxane having the structure:

   ―(CR¹₂)ₑ-[SiR⁴₂-O]_{f}-SiR⁴₂-CR¹₂)_{g}-

   in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10 and f is 1 to 50.
23. The method for preparing an encapsulated electronic component encapsulated in a cured reworkable encapsulant composition, in which the encapsulant composition comprises a mono-functional vinyl compound having the formula 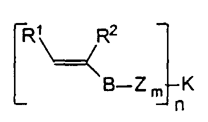 in which B is selected from the group consisting of O, C(O), O-C(O), C(O)-O, C(O)NH and C(O)N(R⁸).
24. The method for preparing an encapsulated electronic component according to paragraph 23 in which Z is a linear or branched chain alkyl, alkyloxy, alkylene, or alkyleneoxy species having up to about 100 atoms in the chain, which may contain saturated or unsaturated cyclic or heterocyclic substituents pendant from the chain or as part of the chain.
25. The method for preparing an encapsulated electronic component according to paragraph 23 in which Z is a linear or branched chain alkyl species having up to about 100 atoms in the chain, which may contain saturated or unsaturated cyclic or heterocyclic substituents pendant from the chain or as part of the chain.
26. The method for preparing an encapsulated electronic component according to paragraph 23 in which Z is a urethane having the structure: 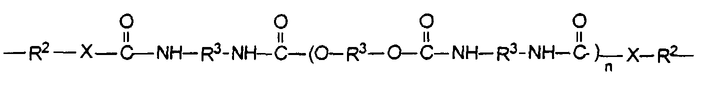 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50.
27. The method for preparing an encapsulated electronic component according to paragraph 23 in which Z is an ester having the structure: 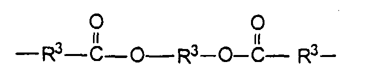 in which R³ is an alkyl or alkyloxy chain having up to 100 atoms in the chain, which chain may contain aryl substituents.
28. The method for preparing an encapsulated electronic component according to paragraph 23 in which Z is a siloxane having the structure:

   ―(CR¹₂)ₑ-[SiR⁴₂-O]_{f}-SiR⁴₂-(CR¹₂)_{g}―

   in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10, and f is 1 to 50.
29. The method for preparing an encapsulated electronic component according to paragraph 23 in which K is 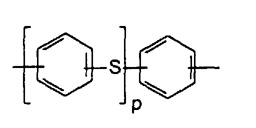 in which p is 1 to 100.
30. The method for preparing an encapsulated electronic component according to paragraph 23 in which K is 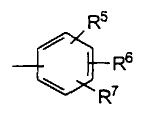 in which R⁵, R⁶, and R⁷ are a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain, and in which any heteroatom present may or may not be directly attached to the aromatic ring.
31. The method for preparing an encapsulated electronic component according to paragraph 23 in which K is 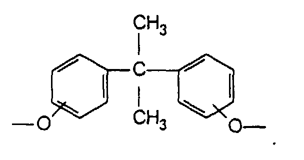
32. The method for preparing an electronic assembly according to any one of the preceding paragraphs in which the reactive oligomers or prepolymers are selected from the group further comprising poly-functional maleimide compounds, poly-functional vinyl compounds other than maleimide compounds, and a combination of poly-functional maleimide and poly-functional vinyl compounds, provided that the polyfunctional compounds are present in an amount ineffective to diminish the thermoplastic properties of the cured composition.
33. The method of preparing an electronic assembly according to any one of the preceding paragraphs in which the curable encapsulant composition further comprises one or more fillers.
34. The method of preparing an electronic assembly according to any one of the preceding paragraphs in which the curable encapsulant composition further comprises one or more adhesion promoters.

## Claims

1. A method for preparing an electronic assembly of a cured reworkable underfill encapsulant composition disposed between the electronic component and the substrate comprising:
(a) providing a curable underfill encapsulant composition formed by combining components comprising
(i) one or more reactive oligomers or prepolymers selected from the group consisting of mono-functional maleimide compounds, mono-functional vinyl compounds other than maleimide compounds, and a combination of mono-functional maleimide and mono-functional vinyl compounds, and
(ii) a curing initiator selected from the group consisting of a free-radical initiator, a photoinitiator, and a combination of free-radical initiator and a photoinitiator;
(b) disposing the curable composition between the electrical component and the substrate; and
(c) curing the composition *in situ.*

2. The method for preparing an encapsulated electronic component according claim 1 in which the maleimide compound has the formula
[M-X ₘ]ₙ - Q
in which
(a) M is a maleimide moiety having the structure: 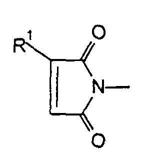 in which R¹ is H or an alkyl group having 1 to 5 carbon atoms;
(b) each X independently is an aromatic group selected from the group of aromatic groups having the structures: 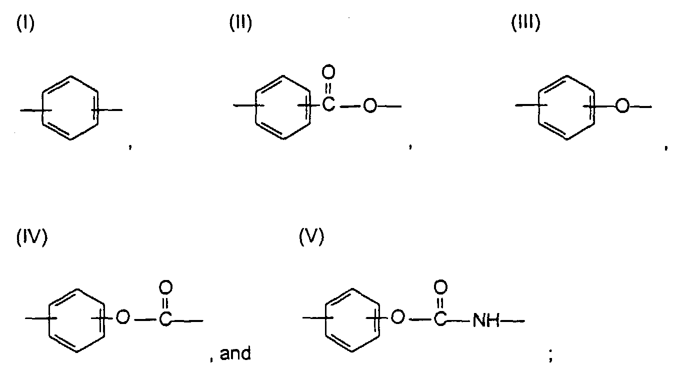
(c) Q is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain, and in which any heteroatom present may or may not be directly attached to X;
or
(d) Q is a urethane having the structure: 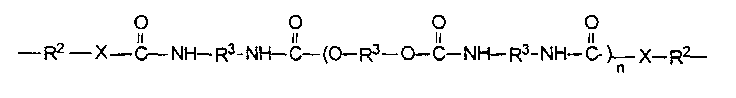 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50; or
(e) Q is an ester having the structure: 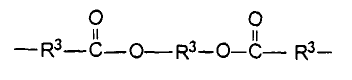 in which R³ is an alkyl or alkyloxy chain having up to 100 atoms in the chain, which chain may contain aryl substituents; or
(f) Q is a siloxane having the structure:
―(CR¹₂)ₑ-[SiR⁴₂-O]_{f}-SiR⁴₂-(CR¹₂)_{g}-
in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10 and f is 1 to 50;
(g) m is 0 or 1;
and
(h) n is 1 to 6.

3. The method for preparing an encapsulated electronic component according to claim 1 in which the maleimide compound has the formula [M-Z ₘ]ₙ - K in which
(a) M is a maleimide moiety having the structure 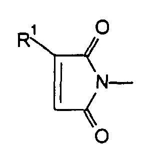 in which R¹ is H or an alkyl having 1 to 5 carbon atoms;
(b) Z is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain, and in which any heteroatom present may or may not be directly attached to K;
or
(c) Z is a urethane having the structure: 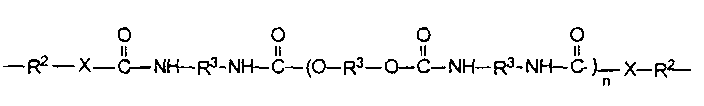 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50;
or
(d) Z is an ester having the structure: 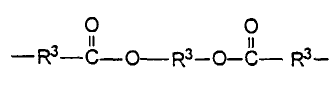 in which R³ is an alkyl or alkyloxy chain having up to 100 atoms in the chain, which chain may contain aryl substituents;
or
(e) Z is a siloxane having the structure:
―(CR¹₂)ₑ-[SiR⁴₂-O]_{f}*-*SiR⁴₂-(CR¹₂)_{g}―
in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10, and f is 1 to 50;
(f) K is an aromatic group selected from group of aromatic groups having the structures: 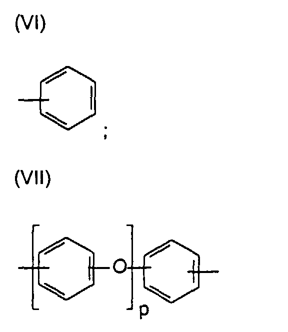 in which p is 1-100, 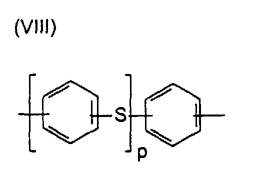 in which p is 1 to 100; 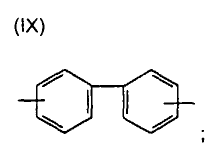 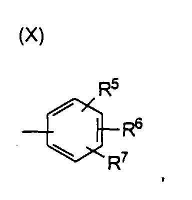 in which R⁵, R⁶, and R⁷ are a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the backbone in the chain, and in which any heteroatom present may or may not be directly attached to the aromatic ring; or
R⁵, R⁶, and R⁷ are a siloxane having the structure ―(CR¹₂)ₑ-[SiR⁴₂-O]ₜ-SiR⁴₂-(CH₃)_{g}- in which the R¹ substituent is H or an alkyl group having 1 to 5 carbon atoms and the R⁴ substituent independently for each position is an alkyl group having 1 to 5 carbon atoms or an aryl group, and e is 1 to 10 and f is 0 to 50; 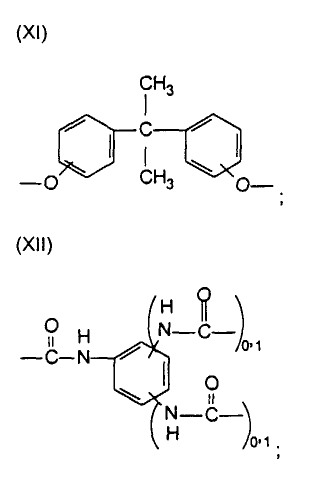 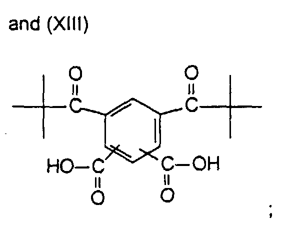
(g) m is 0 or 1;
and
(h) n is 1-6.

4. The method for preparing an encapsulated electronic component according to claim 1 in which the vinyl compound has the formula 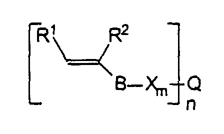 in which
(a) R¹ and R² are H or an alkyl group having 1 to 5 carbon atoms, or together form a 5 to 9 membered ring with the carbons forming the vinyl group;
(b) B is C, S, N, O, C(O), O-C(O), C(O)-O, C(O)NH or C(O)N(R⁸), in which R⁸ is an alkyl group having 1 to 5 carbon atoms;
(c) each X independently is an aromatic group selected from the group of aromatic groups having the structures: 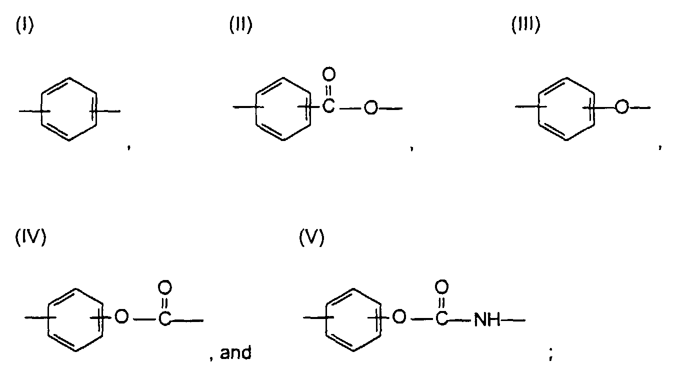
(d) Q is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain; and in which any heteroatom present may or may not be directly attached to X;
or
(e) Q is a urethane having the structure: 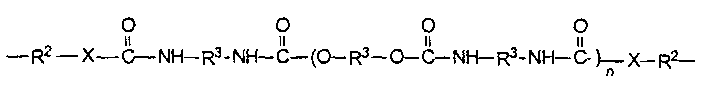 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50;
or
(f) Q is an ester having the structure: 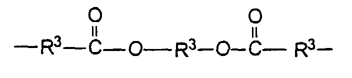 in which R³ is an alkyl or alkyloxy chain having up to 100 atoms in the chain, which chain may contain aryl substituents;
or
(g) Q is a siloxane having the structure:
―(CR¹₂)ₑ-[SiR⁴₂-O]_{f}-SiR⁴₂-(CR¹₂)_{g}―
in which the R¹ substituent independently for each position is H or an alkyl group having 1 to 5 carbon atoms, and the R₄ substituent independently for each position is an alkyl group having 1 to 5 carbon atoms or an aryl group, and e and g are independently 1 to 10 and f is 1 to 50;
(h) m is 0 or 1;
and
(i) n is 1-6.

5. The method for preparing an encapsulated electronic component according to claim 1 in which the vinyl compound has the formula 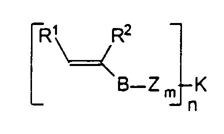 in which
(a) R¹ and R² are H or an alkyl group having 1 to 5 carbon atoms, or together form a 5 to 9 membered ring with the carbons forming the vinyl group;
(b) B is C, S, N, O, C(O), O-C(O), C(O)-O, C(O)NH or C(O)N(R⁸), in which R⁸ is an alkyl group having 1 to 5 carbon atoms;
(c) Z is a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the chain, and in which any heteroatom present may or may not be directly attached to K;
or
(d) Z is a urethane having the structure: 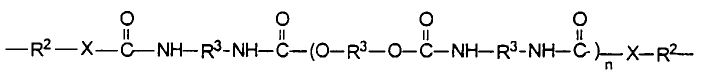 in which each R² independently is an alkyl, aryl, or arylalkyl group having 1 to 18 carbon atoms; R³ is an alkyl or alkyloxy chain having up to 100 atoms in the chain, which chain may contain aryl substituents; X is O, S, N, or P; and n is 0 to 50;
or
(e) Z is an ester having the structure: 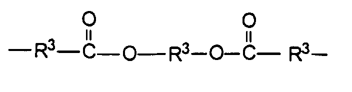 in which R³ is an alkyl or alkyloxy chain having up to 100 atoms in the chain, which chain may contain aryl substituents;
(f) Z is a siloxane having the structure:
―(CR¹₂)ₑ-[SiR⁴₂-O]_{f}-SiR⁴₂-(CR¹₂)_{g}―
in which the R¹ substituent independently for each position is H or an alkyl group having 1 to 5 carbon atoms, and the R⁴ substituent independently for each position is an alkyl group having 1 to 5 carbon atoms or an aryl group, and e and g are independently 1 to 10, and f is 1 to 50;
(g) K is an aromatic group selected from group of aromatic groups having the structures: 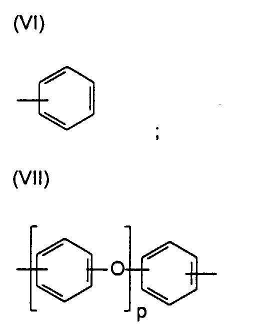 in which p is 1 to 100; 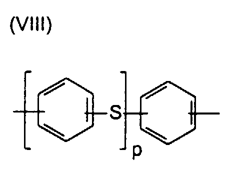 in which p is 1 to 100; 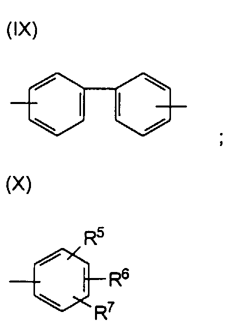 in which R⁵, R⁶, and R⁷ are a linear or branched chain alkyl, alkyloxy, alkyl amine, alkyl sulfide, alkylene, alkyleneoxy, alkylene amine, alkylene sulfide, aryl, aryloxy, or aryl sulfide species having up to about 100 atoms in the chain, which may contain saturated or unsaturated cyclic or heterocyclic substituents pendant from the chain or as part of the backbone in the chain, and in which any heteroatom present may or may not be directly attached to the aromatic ring; or
R⁵, R⁶, and R⁷ are a siloxane having the structure ―(CR¹₂)ₑ-[SiR⁴₂-O]_{f}-SiR⁴₂-(CH₃)_{g}― in which the R¹ substituent is H or an alkyl group having 1 to 5 carbon atoms and the R⁴ substituent independently for each position is an alkyl group having 1 to 5 carbon atoms or an aryl group, and e is 1 to 10 and f is 0 to 50; 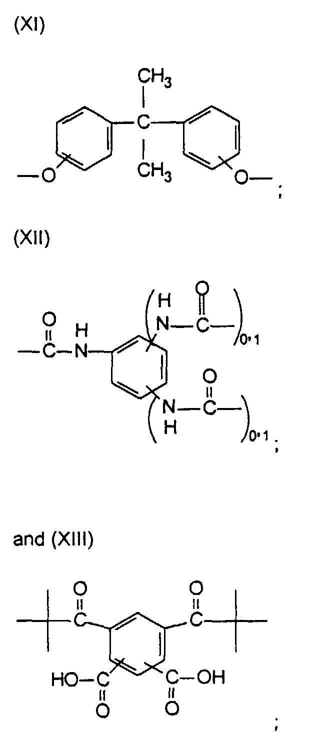
(h) m is 0 ;
and
(i) n is 1-6.
